# EUROPÄISCHE PATENTSCHRIFT

(11) **EP 0 908 014 B1**
(45) Veröffentlichungstag und Bekanntmachung des Hinweises auf die Patenterteilung: **22.08.2001**
(21) Anmeldenummer: 97932706.1
(22) Anmeldetag: 24.06.1997
(51) Int. Cl.: H03K 17/945

(54) **ELEKTRONISCHES SCHALTGERÄT**
ELECTRONIC SWITCH
COMMUTATEUR ELECTRONIQUE

(30) Priorität: 05.07.1996 DE 19627211
(43) Veröffentlichungstag der Anmeldung: 14.04.1999
(73) Patentinhaber: SIEMENS AKTIENGESELLSCHAFT, 80333 München (DE)
(72) Erfinder: RITTHAMMER, Günter, D-92224 Amberg (DE)
(86) Internationale Anmeldenummer: DE9701312
(87) Internationale Veröffentlichungsnummer: WO9801951

(56) Entgegenhaltungen:
- DE-A- 2 407 868
- DE-A- 2 817 020
- DE-A- 3 438 422

## Beschreibung

Die Erfindung bezieht sich auf elektronisches, berührungslos arbeitendes Schaltgerät mit einem Gehäuse, mit einem Sensor und mit einer optischen Anzeige in einer Gehäusewand.

Ein gattungsgemäßes Schaltgerät ist z.B. aus der DE 88 13 185 U1 bekannt. Hier handelt es sich um einen induktiven Näherungsschalter, der aus einem Gehäuse und einer in diesem angebrachten elektronischen Schaltung besteht. Der Näherungsschalter umfaßt als Sensor ein induktives Element und ein Schaltorgan, das nach externer Beeinflussung des elektromagnetischen Feldes des induktiven Elementes seinen Schaltzustand verändert. Der Annäherungsschalter ist mit Befestigungslöchern und mit Befestigungsschlitzen versehen, so daß einerseits eine Befestigung in einer fixierten Stellung und andererseits eine variable Einstellung über die Befestigungsschlitze möglich ist. Die lichtemittierende Diode als optische Anzeige ist in einer Öffnung des Gehäuses untergebracht. Eine variable Ausrichtung der Diode in eine bestimmte frei wählbare Richtung ist hier nicht möglich.

Aus der DE 35 39 252 C2 ist ein elektronisch arbeitendes Schaltgerät, hier ein Näherungsschalter, bekannt, der ein Gehäuse, einen Sensor und eine optische Anzeige in der Gehäusewand aufweist. Das Gehäuse des Näherungsschalters besteht aus ineinandergesteckten Hülsen, die fest miteinander verbunden sind und als Gehäuseoberteil und Gehäuseunterteil angesehen werden können. Die Montage des Näherungsschalters erfolgt in der Weise, daß ein hülsenförmiger Gehäuseteil mit einem Zentrierbund in die offene Seite des Gehäuseoberteils eingepreßt wird und anschließend das Gehäuseunterteil über den hülsenförmigen Gehäuseteil geschoben und auf einen Bund am freien Ende des Gehäuseoberteils aufgepreßt wird. Somit ist eine Ausrichtung der optischen Anzeige des Näherungsschalters nur möglich, in dem dieser insgesamt entsprechend gedreht wird.

Zum Erkennen freier und belegter Stellplätze in Parkhäusern eignen sich elektronisch, insbesondere berührungslos arbeitende Schaltgeräte. Diese sollen leicht, sicher und schnell an der Decke des Parkhauses montierbar sein. Mittels Sensoren sollen die Belegdaten zur Steuerung eines Parkhaus-Leitsystems erfaßt werden, um den Parkplatzsuchenden sicher und auf kürzestem Wege zu einem freien Stellplatz zu leiten. Die bisher üblichen Schaltgeräte werden bisher mittels Dübel und Schrauben oder durch Anschluß über Schraubklemmen montiert. Eine nachträgliche Ausrichtung ihrer optischen Anzeige in eine bestimmte Richtung ist nicht möglich.

DE 3 438 422 A offenbart ein elektronisches, berührungslos arbeitendes Schaltgerät mit den Merkmalen gemäß dem Oberbegriff des Anspruchs 1.

Der Erfindung liegt die Aufgabe zugrunde, ein Schaltgerät der obengenannten Art zu schaffen, bei dem die optische Anzeige nach Montage des Schaltgeräts innerhalb eines bestimmten Winkelbereichs in eine bestimmte Richtung ausgerichtet werden kann.

Diese Aufgabe wird gemäß den Merkmalen nach Anspruch 1 gelöst.

Weitere vorteilhafte Ausbildungen der Erfindung sind den Unteransprüchen zu entnehmen.

Um Wasser, z.B. Spritzwasser oder Kondensat, an der rückseitigen Oberfläche des Schaltgerätes abzuführen, ist es vorteilhaft, wenn das Gehäuseunterteil eine Mulde mit einer Wasserablauföffnung aufweist.

Vorteilhafterweise ist der Sensor am Boden des Gehäuseoberteils eingegossen.

Ein Ausführungsbeispiel der Erfindung wird im folgenden anhand einer Zeichnung näher erläutert. Es zeigen:
- FIG 1: eine Innenansicht des erfindungsgemäßen Schaltgeräts nach teilweisem Schnitt des Gehäuseoberteils,
- FIG 2: eine Rückansicht des Schaltgeräts gemäß FIG 1,
- FIG 3: eine perspektivische Ansicht des Schaltgeräts in Verbindung mit einem zur Montage verwendeten Flachkabel-Modul und
- FIG 4: eine Teilansicht von Gehäuseoberteil und -unterteil im Bereich ihrer formschlüssigen Verbindung.

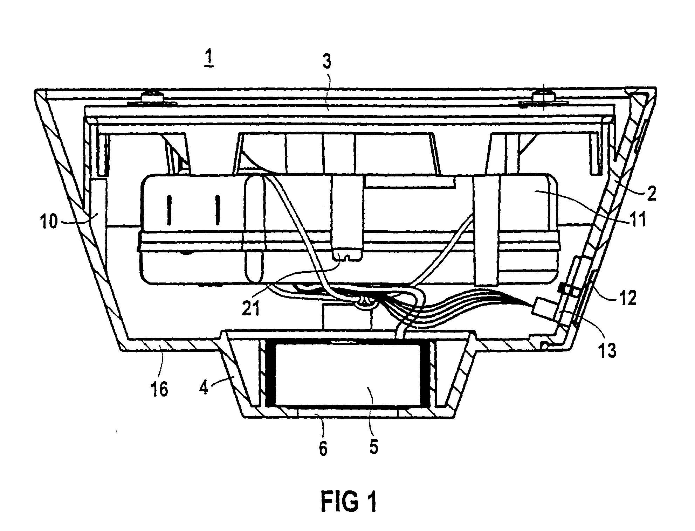

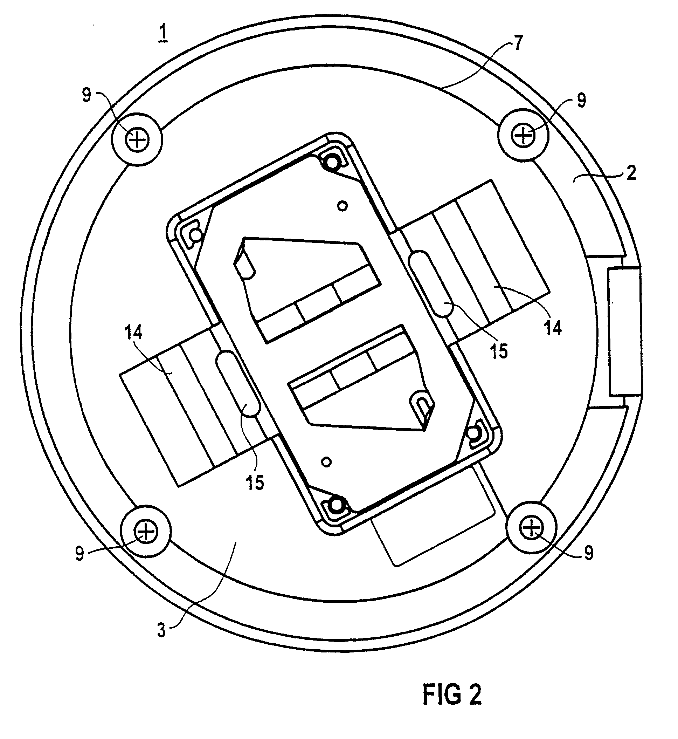

FIG 1 zeigt ein elektronisches, insbesondere berührungslos arbeitendes Schaltgerät 1, hier einen Ultraschall-Näherungsschalter, der zur Erfassung freier und belegter Stellplätze in einem Parkhaus dient. Der Ultraschall-Näherungsschalter 1 ist aus einem im Gehäuseoberteil 2 und einem Gehäuseunterteil 3 zusammengesetzt. Das Gehäuseoberteil 2 ist kegelstumpfförmig ausgebildet und weist auf seiner Vorderseite eine Ausformung 4 auf, in der ein Ultraschallsensor 5 liegt. Die Ausformung 4 ist zur ungehinderten Ausbreitung der Ultraschallwellen mit einer Öffnung 6 versehen. Auf der Rückseite ist das Gehäuseoberteil 2 durch das Gehäuseunterteil 3 abgedeckt. Das Gehäuseunterteil 3 weist gemäß FIG 2 einen Rand 7 mit kreisförmiger Randkontur auf. Das Gehäuseoberteil 2 ist mit einem an diese Randkontur angepaßten Absatz 8 versehen, in dem das Gehäuseunterteil 3 über seinen Rand 7 formschlüssig aufgenommen und z.B. durch Schrauben 9 als Halterungsmittel gehalten ist. Dabei werden Schrauben 9 mit einem möglichst breiten Kopf verwendet oder die Befestigung in Verbindung mit Unterlegscheiben vorgenommen. Zwischen den Schrauben 9 bzw. Unterlegscheiben und dem Absatz 8 kann der Rand 7 des Gehäuseunterteils 3 sich in einem Spalt drehen, wobei der maximale Bereich der Drehbarkeit durch eine Anschlagnocke 10 im Gehäuseoberteil 2 z.B. auf 360° beschränkt ist (FIG 1). In dem durch das Gehäuseoberteil 2 und das Gehäuseunterteil 3 gebildeten Innenraum ist ein zweiteiliges Blechgehäuse 11 mit der Elektronik für das Schaltgerät 1 gelagert. In einer Seitenwand des Gehäuseoberteils 2 ist ein Fenster mit einer optischen Anzeige 13 vorgesehen, die über die Elektronik angesteuert wird.

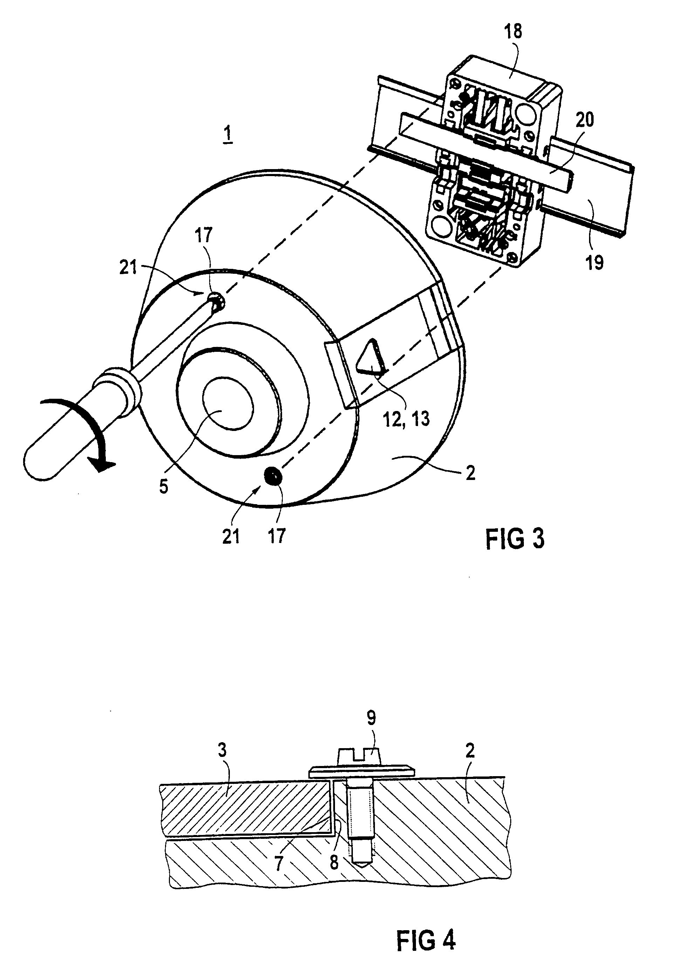

FIG 2 zeigt die Rückseite des Schaltgeräts 1. Über die vier Schrauben 9 ist der Rand 7 des Gehäuseunterteils 3 in dem Absatz 8 des Gehäuseoberteils 2 drehbar festgelegt. Im Gehäuseunterteil 3 ist eine Mulde 14 mit Wasserablauföffnungen 15 eingeformt, über die Spritzwasser von außen oder Kondensat an der rückseitigen Oberfläche des Schaltgeräts 1 gezielt abgeführt werden kann. Das Wasser dringt in den Innenraum des Schaltgeräts 1 ein und wird über am Boden des Gehäuseoberteils 2 befindliche Schrauböffnungen 17 ausgeleitet (siehe FIG 3). Über die genannten Schraubenöffnungen 17 wird das Schaltgerät 1 bei der Montage mittels in der FIG 3 nicht sichtbarer Schrauben 21 (nur durch Pfeil angedeutet) an einem Flachkabelmodul 18 befestigt. Das Flachkabelmodul 18 ist auf eine Hutschiene 19 aufgeschnappt. Nach Verkabelung des Flachkabelmoduls wird auf dieses das Schaltgerät 1 aufgesteckt und mittels zweier vormontierter Schrauben 21 an dem Flachkabelmodul 18 festverbunden, wobei zwangsläufig eine Kontaktierung mit dem Flachkabel erfolgt. Durch das Anschrauben des Schaltgerätes 1 an dem Flachkabelmodul 18 geben die beiden Schrauben 21 die Verbindung (Fixierung) zwischen Gehäuseoberteil und Gehäuseunterteil frei, so daß die optische Anzeige 11 des Schaltgerätes 1 durch Drehen des Gehäuseoberteils 2 in jede beliebige Richtung ausgerichtet werden kann.

Die optische Anzeige 11 des Schaltgeräts 1 kann durch Drehen des Gehäuseoberteils 2 in jede beliebige Richtung ausgerichtet werden. Damit eignet sich das Schaltgerät 1 zur Anwendung in Parkhäusern, da die optische Anzeige in Richtung der ankommenden Fahrzeuge ausgerichtet werden kann.

Die Teilansicht in FIG 4 zeigt das formschlüssige Ineinandergreifen des kreisförmigen Randes 7 des Gehäuseunterteils 3 in den Absatz 8 des Gehäuseoberteils 2. Die Halterung des Gehäuseunterteils 3 wird über Schrauben 9 erreicht, die zusammen mit dem Absatz 8 einen Spalt bilden, durch den der Rand 7 geführt umlaufen kann.

Obwohl die vorliegende Erfindung unter Bezugnahme auf die in der beigefügten Zeichnung dargestellte Ausführungsform erläutert ist, sollte berücksichtigt werden, daß damit nicht beabsichtigt ist, die Erfindung nur auf die dargestellte Ausführungsform zu beschränken, sondern alle möglichen Änderungen, Modifizierungen und Anordnungen, soweit sie vom Inhalt der Patentansprüche gedeckt sind, einzuschließen.

## Patentansprüche

1. Elektronisches, berührungslos arbeitendes Schaltgerät (1) mit einem Gehäuse (2,3), mit einem Sensor (5) in dem Gehäuse und mit einer optischen Anzeige (11) in einer Gehäusewand, wobei in einer Seitenwand eines Gehäuseoberteils (2) eine optische Anzeige (11) vorgesehen ist und wobei das Gehäuseoberteil (2) eine Öffnung (6) aufweist, über die die berührungslose Erfassung mit dem Sensor (5) erfolgt, **dadurch gekennzeichnet**, daß das Gehäuse aus einem Gehäuseunterteil (3) und dem demgegenüber drehbaren Gehäuseoberteil (2) zusammengesetzt ist.

2. Elektronisches, berührungslos arbeitendes Schaltgerät (1) nach Anspruch 1, **dadurch gekennzeichnet**, daß das im wesentlichen plattenförmige Gehäuseunterteil (3) einen Rand (7) mit einer Randkontur und das Gehäuseoberteil (2) einen der Randkontur angepaßten Absatz (8) aufweisen, in dem das Gehäuseunterteil (3) über seinen Rand (7) formschlüssig aufgenommen und durch Halterungsmittel (9) gehalten ist.

3. Elektronisches, berührungslos arbeitendes Schaltgerät nach Anspruch 2, **dadurch gekennzeichnet**, daß die Halterungsmittel (9) zusammen mit dem Absatz (8) einen Spalt zum geführten Umlauf des Randes (7) bilden.

4. Elektronisches, berührungslos arbeitendes Schaltgerät nach einem der vorangehenden Ansprüche, **dadurch gekennzeichnet**, daß das Gehäuseunterteil (3) eine Mulde (14) mit einer Wasserablauföffnung (15) aufweist.

5. Elektronisches, berührungslos arbeitendes Schaltgerät nach einem der vorangehenden Ansprüche, **dadurch gekennzeichnet**, daß das Gehäuseoberteil (2) mit einem Anschlagnocken (10) versehen ist, durch den der maximale Bereich der Drehbarkeit des Gehäuseoberteils (2) zum Gehäuseunterteil (3) beschränkt ist.

6. Elektronisches, berührungslos arbeitendes Schaltgerät nach einem der vorangehenden Ansprüche, **dadurch gekennzeichnet**, daß der Sensor (5) am Boden (16) des Gehäuseoberteils (2) eingegossen ist.

## Claims

1. Electronic, contactless switching device (1) with a housing (2, 3), with a sensor (5) in the housing and with a visual indicator (11) in a housing wall, whereby in a side wall of an upper housing section (2) a visual indicator (11) is provided and whereby the upper housing section (2) has an opening (6) through which the contactless detection by means of the sensor (5) takes place, characterised in that the housing consists of a lower housing section (3) and the upper housing section (2) which can be rotated relative to it.

2. Electronic, contactless switching device (1) in accordance with claim 1, characterised in that the lower housing section (3), which is essentially plate-shaped, has a rim (7) with a rim contour and that the upper housing section (2) has a shoulder (8) matched to the rim contour, in which the lower housing section (3) is located positively by its rim (7) and retained by retaining means (9).

3. Electronic contactless switching device according to claim 2, characterised in that the retaining means (9) together with the shoulder (8) forms a gap for the guided circulation of the rim (7).

4. Electronic contactless switching device in accordance with one of the previous claims, characterised in that the lower housing section (3) has a trough (14) with a water drain opening (15).

5. Electronic contactless switching device in accordance with one of the proceeding claims, characterised in that the upper housing section (2) is provided with a stop cam (10) by means of which the maximum range of rotation of the upper housing section (2) relative to the lower housing section (3) is limited.

6. Electronic contactless switching device in accordance with one of the previous claims, characterised in that the sensor (5) is encapsulated in the bottom (16) of the upper housing section (2).

## Revendications

1. Commutateur (1) électronique fonctionnant sans contact, comprenant un boîtier (2, 3), un capteur (5) dans le boîtier et un affichage (11) optique dans une paroi du boîtier, l'affichage (11) optique étant prévu dans une paroi latérale d'une partie (2) supérieure du boîtier et la partie (2) supérieure du boîtier comportant une ouverture par laquelle s'effectue la détection sans contact par le capteur (5), caractérisé en ce que le boîtier est composé d'une partie (3) inférieure de boîtier et d'une partie (2) supérieure de boîtier pouvant tourner par rapport à celle-ci.

2. Commutateur (1) électronique fonctionnant sans contact suivant la revendication 1, caractérisé en ce que la partie (3) inférieure de boîtier sensiblement sous forme de plaque a un bord (7) ayant un contour et la partie (2) supérieure de boîtier a un renfoncement (8) qui est adapté au contour et dans lequel la partie (3) inférieure de boîtier est reçue à complémentarité de forme par son bord (7) et est maintenue par des moyens (9) de fixation.

3. Commutateur (1) électronique fonctionnant sans contact suivant la revendication 2, caractérisé en ce que les moyens (9) de fixation forment ensemble avec le renfoncement (8) une fente pour que le bord (7) puisse tourner en étant guidé.

4. Commutateur (1) électronique fonctionnant sans contact suivant l'une des revendications précédentes, caractérisé en que la partie (3) inférieure de boîtier comporte une cuvette (14) ayant un orifice (15) d'évacuation de l'eau.

5. Commutateur (1) électronique fonctionnant sans contact suivant l'une des revendications précédentes, caractérisé en ce que la partie (2) supérieure de boîtier est munie d'une came (10) de butée par laquelle la possibilité maximum de tourner de la partie (2) supérieure de boîtier par rapport à la partie (3) inférieure de boîtier est limitée.

6. Commutateur (1) électronique fonctionnant sans contact suivant l'une des revendications précédentes, caractérisé en ce que le capteur (5) est incorporé au fond (16) de la partie (2) supérieure de boîtier.
